(19) Europäisches Patentamt
European Patent Office
Office européen des brevets

(11) **EP 4 034 922 B1**

(12) **FASCICULE DE BREVET EUROPEEN**

(45) Date de publication et mention de la délivrance du brevet:
**15.11.2023 Bulletin 2023/46**

(21) Numéro de dépôt: **20780675.3**

(22) Date de dépôt: **24.09.2020**

(51) Classification Internationale des Brevets (IPC):
**G02B 5/18** (2006.01)   **H01S 5/125** (2006.01)

(52) Classification Coopérative des Brevets (CPC):
**G02B 5/1861; H01S 5/021; H01S 5/125; H01S 5/141;** H01S 5/1032

(86) Numéro de dépôt international:
**PCT/EP2020/076798**

(87) Numéro de publication internationale:
**WO 2021/058689 (01.04.2021 Gazette 2021/13)**

(54) **MIROIR DE BRAGG ET PROCÉDÉ DE RÉALISATION D'UN MIROIR DE BRAGG**

BRAGG-SPIEGEL UND VERFAHREN ZUM PRODUZIEREN EINES BRAGG-SPIEGELS

BRAGG MIRROR AND METHOD FOR PRODUCING A BRAGG MIRROR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.09.2019 FR 1910714**

(43) Date de publication de la demande:
**03.08.2022 Bulletin 2022/31**

(73) Titulaire: **Commissariat à l'Energie Atomique et aux Energies Alternatives**
**75015 Paris (FR)**

(72) Inventeurs:
• **SCIANCALEPORE, Corrado**
**38054 GRENOBLE (FR)**
• **EL DIRANI, Houssein**
**38054 GRENOBLE (FR)**

(74) Mandataire: **Hautier IP**
**20, rue de la Liberté**
**06000 Nice (FR)**

(56) Documents cités:
**WO-A2-2005/089098**

• **HAN YUN ET AL: "Broadband 2?x?2 adiabatic 3??dB coupler using silicon-on-insulator sub-wavelength grating waveguides", OPTICS LETTERS, vol. 41, no. 13, 1 juillet 2016 (2016-07-01), page 3041, XP055696463, US ISSN: 0146-9592, DOI: 10.1364/OL.41.003041**
• **D. BORDEL ET AL: "Heterogeneously Integrated III-V/Si Distributed Bragg Reflector Laser with Adiabatic Coupling", 39TH EUROPEAN CONFERENCE AND EXHIBITION ON OPTICAL COMMUNICATION (ECOC 2013), 1 janvier 2013 (2013-01-01), pages 687-689, XP055197576, DOI: 10.1049/cp.2013.1502 ISBN: 978-1-84-919759-5**

## Description

DOMAINE TECHNIQUE

La présente invention concerne le domaine de l'optoélectronique. Elle trouve pour application particulièrement avantageuse la réalisation de miroirs de Bragg pour des sources laser à semiconducteurs, par exemple pour des lasers de télédétection LiDAR (acronyme de l'expression en langue anglaise « laser détection and ranging » soit en français « détection et estimation de la distance par laser ») ou pour des lasers datacom moyenne distance de type 400G Ethernet.

ÉTAT DE LA TECHNIQUE

Un miroir de Bragg permet de réfléchir un rayonnement lumineux en incidence normale audit miroir, en limitant les pertes optiques. Il peut ainsi présenter une réflectivité R supérieure à 99% pour un rayonnement lumineux de longueur d'onde λ donnée.

Les miroirs de Bragg sont donc particulièrement avantageux pour la fabrication de cavités optiques pour des applications laser, et notamment pour des sources laser à semiconducteurs.

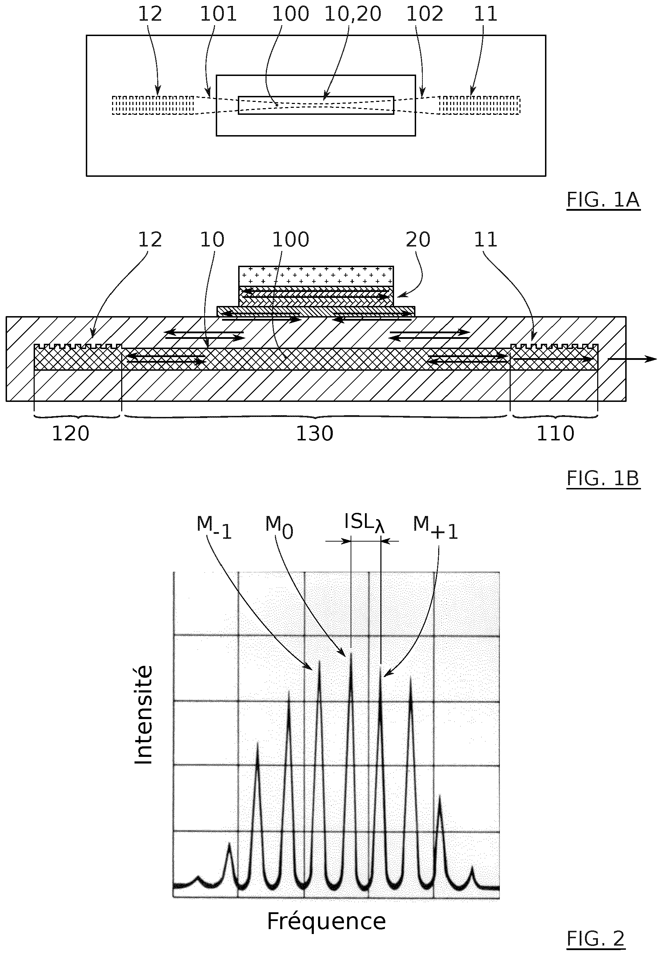

Une architecture connue de source laser à semiconducteurs est présentée aux figures 1A, 1B. Une telle architecture comprend typiquement un guide en ruban 100 s'étendant longitudinalement entre deux miroirs de Bragg 11, 12, transverses, et une cavité optique de type Fabry-Pérot comprenant un milieu amplificateur 20. Le milieu amplificateur 20 est ici une vignette en matériau III-V, par exemple en phosphure d'indium InP, reportée sur le ruban 100 en silicium. En pratique, les miroirs de Bragg sont réalisés par corrugation du guide en ruban 100. Ils présentent dès lors chacun un facteur de corrugation $\kappa$ et une longueur $L_g$ qui déterminent leurs propriétés de réflectivité.

Le facteur de corrugation $\kappa$ peut s'exprimer selon :

$$\kappa = \frac{\pi . n_{eff,g}}{\lambda} \frac{\int\int_{\Omega} n_{inf}^2 n_{sup}^2 E^2 dxdy}{\iint E^2 dxdy}$$

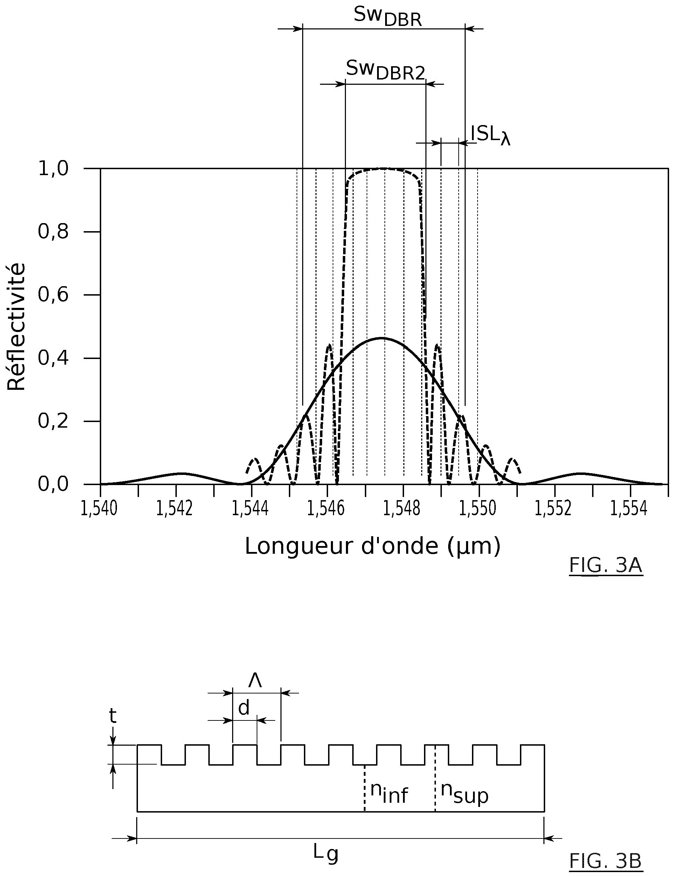

Où $\Omega$ est la section du mode optique se propageant dans le ruban, $n_{inf}$ et $n_{sup}$ sont respectivement les indices de réfraction effectifs du mode optique en correspondance avec respectivement les marches basses et les marches hautes du ruban comme illustré à la figure 3B, $n_{eff,g} = (n_{inf} - n_{sup})d\Lambda + n_{sup}$ est un indice effectif global du réseau formé par les corrugations (moyenne pondérée des indices liés aux marches basses et marches hautes) et E est le champ électrique du rayonnement lumineux en dehors de la région perturbée par les corrugations.

Un principe de fonctionnement de cette source laser est le suivant : le milieu amplificateur est pompé électriquement de façon à émettre un rayonnement lumineux présentant un spectre d'émission centré autour d'une longueur d'onde λ. Ce rayonnement lumineux se propage de façon guidée au sein de la cavité optique en étant réfléchi plusieurs fois par les miroirs de Bragg, selon un mode de propagation résonant appelé mode de cavité ou mode longitudinal. Après chaque réflexion, le rayonnement lumineux est réinjecté dans le milieu amplificateur de façon à stimuler l'émission. L'un des miroirs de Bragg, dit de confinement, présente une réflectivité R ≥ 99% et permet de limiter les pertes optiques de la cavité. L'autre miroir de Bragg, dit de sortie ou d'extraction, est partiellement réfléchissant (R ≤ 50%) et permet de transmettre un faisceau laser cohérent.

Ce faisceau laser présente généralement un spectre d'émission comprenant un ensemble discret de raies très fines autour de la longueur d'onde λ, à des longueurs d'onde définies par la cavité optique et le milieu amplificateur. Ce spectre d'émission du laser est illustré à la figure 2. Les différentes raies de ce spectre d'émission correspondent aux modes longitudinaux du faisceau laser. La largeur des raies dépend notamment des imperfections de la cavité optique et du bruit quantique généré au sein du milieu amplificateur.

L'espacement en longueur d'onde entre les modes longitudinaux correspond à l'intervalle spectral libre $ISL_\lambda$ (ou FSR en anglais, pour *free spectral range*) de la cavité optique, et dépend notamment de la longueur L de la cavité optique :

$$ISL_\lambda = \frac{\lambda^2}{2n_{eff}L}$$

Avec $n_{eff}$ l'indice effectif moyen de la cavité optique. Ainsi, en augmentant la longueur de cavité, l'$ISL_\lambda$ diminue et la bande spectrale du faisceau laser contient potentiellement plus de modes longitudinaux.

Le faisceau laser peut être caractérisé par sa pureté spectrale, qui reflète le nombre de modes longitudinaux de son spectre d'émission. La pureté spectrale du faisceau laser augmente lorsque le nombre de modes longitudinaux dans le spectre d'émission diminue. La pureté spectrale peut être exprimée comme le rapport des intensités des deux raies les plus intenses. En télécommunication, un faisceau laser est considéré comme monomode de longueur d'onde λ si ce rapport d'intensités, également connu sous l'acronyme SMSR (pour *Side Mode Suppression Ratio* en anglais, soit en français « ratio de suppression de la bande latérale »), est supérieur à environ 30 dB.

Une solution permettant d'améliorer la pureté spectrale du faisceau laser consiste à réduire la longueur de cavité. Ce type de solution n'est pas adapté pour des sources laser nécessitant une puissance optique élevée puisqu'en réduisant la longueur de cavité, la puissance optique du faisceau laser diminue.

Une autre solution permettant d'améliorer la pureté spectrale du faisceau laser consiste à dimensionner le miroir de Bragg de sortie de façon à filtrer spectralement le faisceau laser.

Les miroirs de Bragg de la cavité optique présentent chacun un pic de réflectivité centré sur la longueur d'onde λ.

Ce pic de réflectivité présente une certaine largeur spectrale $\delta\omega_{DBR}$ définissant la bande d'arrêt spectral ou « stopband » du miroir de Bragg.

Cette largeur de stopband $\delta\omega_{DBR}$ (en nm) dépend notamment du facteur de corrugation $\kappa$ du réseau de Bragg, également dénommé force du réseau, et de la longueur du réseau de Bragg $L_g$ :

$$\delta\omega_{DBR} = \frac{\pi}{v_g \sqrt{|\kappa|^2 + \left(\frac{\pi}{L_g}\right)^2}}$$

Où $v_g$ est la vitesse de groupe du rayonnement lumineux.

Une largeur de stopband $\delta\omega_{DBR}$ du miroir de sortie suffisamment faible permet de filtrer le spectre d'émission du faisceau laser et de réduire la largeur de ce spectre d'émission. La pureté spectrale du faisceau laser est ainsi d'autant meilleure que la stopband du miroir de sortie est étroite.

La figure 3A illustre la réflectivité R et la stopband du miroir de confinement ($L_g$ = 500 μm, R ≈ 100%, $\delta\omega_{DBR2}$ ≈ 2 nm) et du miroir de sortie ($L_g$ = 100 μm, R ≈ 46%, $\delta\omega_{DBR}$ ≈ 4 nm) d'une cavité optique d'$ISL_\lambda$ = 0,32 nm, pour un rayonnement lumineux de longueur d'onde λ = 1547 nm. Les lignes verticales illustrent les différents modes longitudinaux du faisceau, séparés par l'$ISL_\lambda$.

Dans cet exemple, la cavité optique présente une longueur $L$ de l'ordre de 1 mm, et les miroirs de confinement et de sortie présentent des corrugations de hauteur $t$ = 10 nm. La figure 3B illustre en coupe un miroir de Bragg de longueur $L_g$ présentant de telles corrugations de hauteur $t$, de longueur $d$ sur une période $\Lambda$.

Ce type de solution permet d'obtenir des sources laser infrarouge (λ ≈ 1550 nm) monomode pour des applications de transmission de données (datacoms) ou de télécommunications (télécoms) nécessitant une puissance optique comprise entre 5 mW et 20 mW.

En revanche, pour des applications de type LiDAR (télédétection par laser) ou des applications datacom moyenne distance de type 400G Ethernet, ce type de solution ne permet pas d'obtenir à la fois une puissance suffisante, typiquement supérieure à 100 mW, et un faisceau laser monomode.

Pour atteindre les puissances optiques requises pour ces applications, la longueur du milieu amplificateur et donc la longueur $L$ de la cavité optique doivent être augmentées. En particulier, la longueur de la cavité optique peut être au moins trois fois plus grande que celle de l'exemple précédent. Cette augmentation de longueur de cavité induit proportionnellement une diminution de l'intervalle spectral libre $ISL_\lambda$.

Les caractéristiques du miroir de sortie de l'exemple précédent ne permettent plus d'obtenir un faisceau monomode pour une telle cavité optique. En particulier, la largeur de stopband du miroir de sortie ($\delta\omega_{DBR}$ ≈ 4 nm) est trop grande en regard de l'intervalle spectral libre ($ISL_\lambda$ ≈ 0,11 nm) d'une telle cavité optique.

Il existe donc un besoin consistant à proposer un miroir de Bragg de sortie pour un laser à semiconducteur présentant une largeur de stopband réduite.

Un objet de la présente invention est de proposer un tel miroir de Bragg de sortie.

En particulier, un objet de la présente invention est de proposer un miroir de Bragg de sortie pour un laser à semiconducteur améliorant la pureté spectrale du faisceau laser, notamment pour un laser à semiconducteur présentant une puissance optique supérieure ou égale à 100 mW.

Un autre objet de la présente invention est de proposer un procédé de réalisation d'un tel miroir de Bragg de sortie.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du miroir de Bragg peuvent s'appliquer *mutatis mutandis* au système optique et/ou au procédé, et réciproquement. Le document WO 2005/089098 A2 est pertinent pour la présente invention.

RESUME

Pour atteindre cet objectif, un premier aspect concerne un miroir de Bragg selon les revendications, comprenant une première partie de ruban à base d'un premier matériau présentant un premier indice de réfraction n1, ledit ruban s'étendant principalement selon une première direction x et étant destiné à guider une propagation d'un rayonnement lumineux de longueur d'onde λ selon ladite première direction x, le miroir de Bragg comprenant en outre des corrugations au niveau d'au moins une face de ladite première partie de ruban, lesdites corrugations s'étendant principalement selon une deuxième direction y normale à la première direction x et présentant une hauteur h3 selon une troisième direction z normale aux première et deuxième directions x, y.

Avantageusement, les corrugations sont séparées de ladite au moins une face de la première partie de ruban par une couche de séparation à base d'un deuxième matériau présentant une épaisseur e2 prise selon la troisième direction z et présentant un deuxième indice de réfraction n2.

Avantageusement, les corrugations sont à base d'un troisième matériau présentant un troisième indice de réfraction n3, tel que n2 < n3 et n2 < n1.

Ainsi, les corrugations sont en regard de la face du ruban et séparées de ladite face du ruban par la couche de séparation.

Le ruban guide la propagation du rayonnement lumineux selon x, longitudinalement. Le ou les modes optiques du rayonnement lumineux sont donc confinés dans le ruban. Le ruban présente ainsi des dimensions selon les directions transverses y, z inférieures et de préférence très inférieures à sa dimension selon x, et par exemple au moins 100 fois plus petite pour au moins une des directions y, z. Le confinement est typiquement obtenu en gainant le ruban par un matériau à faible indice de réfraction. Le confinement se fait ainsi par contraste d'indices, entre le ruban lui-même et la gaine entourant le ruban. Le confinement optique peut également être en partie dû à la géométrie du ruban, typiquement à la forme de sa section transverse.

Un tel ruban formant un guide optique est donc distinct d'un substrat, qui s'étend généralement à la fois en x et en y. Un substrat ne permet pas de guider une propagation d'un rayonnement lumineux selon une direction ou selon une seule direction. Un substrat est typiquement destiné à porter une pluralité de dispositifs. En particulier, un substrat peut porter le guide en ruban associé au miroir de Bragg selon l'invention.

Le ruban et le miroir comprenant une partie de ce ruban sont ainsi destinés au domaine de l'optique guidée. Le ruban est de préférence monomode, c'est-à-dire qu'il guide un seul mode de propagation du rayonnement lumineux, typiquement le mode fondamental. La partie de ruban intégrée au miroir présente typiquement les mêmes caractéristiques que le ruban lui-même. Cette partie de ruban permet en particulier de confiner le rayonnement lumineux. Des fractions du rayonnement lumineux confiné dans la partie de ruban du miroir sont ainsi réfléchies selon x, par chacune des corrugations du miroir. Les fractions réfléchies en phase reforment ainsi un rayonnement lumineux réfléchi selon x. Le miroir assure donc une fonction primaire de réflexion, mais comprend aussi une fonction de propagation de lumière.

Les corrugations perturbent la propagation du rayonnement lumineux. Le facteur de corrugation $\kappa$ détermine ainsi en partie la largeur de stopband $\delta\omega_{DBR}$. Plus le facteur de corrugation est important, plus la largeur de stopband du miroir augmente. A contrario, lorsque le facteur de corrugation diminue, la largeur de stopband du miroir diminue.

Une solution permettant de diminuer le facteur de corrugation consiste à diminuer la hauteur des corrugations. Dans le cadre du développement de la présente invention, il s'est avéré en pratique que les technologies de gravure requises pour obtenir de façon reproductible et maîtrisée des corrugations présentant une hauteur de l'ordre de quelques nanomètres sont très difficiles à mettre en oeuvre.

Au contraire, dans le cas présent, la diminution du facteur de corrugation est obtenue en s'affranchissant d'une diminution de hauteur des corrugations.

Ainsi, l'utilisation d'une couche de séparation permet d'éloigner physiquement les corrugations du ruban dans lequel se propage le rayonnement lumineux. L'intensité des perturbations décroît avec l'augmentation de distance, selon la troisième direction z, entre les corrugations et le ruban. Le facteur de corrugation $\kappa$ et la largeur de stopband $\delta\omega_{DBR}$ du miroir de Bragg sont ainsi diminués par cet effet d'éloignement ou de séparation physique.

L'utilisation d'un deuxième matériau pour cette couche de séparation, typiquement un matériau diélectrique, présentant un faible indice de réfraction relativement à ceux du ruban et des corrugations permet en outre de séparer optiquement les corrugations du ruban dans lequel se propage le rayonnement lumineux.

La couche de séparation d'indice de réfraction n2 a donc un effet synergique en éloignant physiquement les corrugations du ruban, et en modulant optiquement le rayonnement lumineux avec un faible indice. Cela permet de diminuer d'autant plus la largeur de stopband du miroir de Bragg.

Les corrugations sont ainsi « flottantes » vis-à-vis du ruban. D'un point de vue électromagnétique, les corrugations forment des ilots perturbant le champ électromagnétique du rayonnement lumineux se propageant dans le ruban. Les perturbations électromagnétiques du rayonnement lumineux sont atténuées par une barrière diélectrique. Elles décroissent en outre naturellement avec l'augmentation de distance entre les ilots et le ruban. Ces corrugations flottantes présentent un facteur de corrugation diminué.

Un autre aspect concerne un procédé de fabrication d'un miroir de Bragg selon les revendications, comprenant les étapes suivantes :

- Fournir un ruban à base d'un premier matériau présentant un premier indice de réfraction n1, ledit ruban s'étendant principalement selon une première direction x et présentant une face s'étendant dans un plan d'extension principal xy formé par la première direction x et une deuxième direction y normale à la première direction x,

- Déposer au moins sur une première partie de ladite face du ruban une couche de séparation à base d'un deuxième matériau présentant un deuxième indice de réfraction n2 tel que n2 < n1, ladite couche de séparation présentant une épaisseur e2 prise selon une troisième direction z normale aux première et deuxième directions x, y,

- Déposer, sur la couche de séparation, une couche de perturbation à base d'un troisième matériau présentant un troisième indice de réfraction n3, tel que n2 < n3, ladite couche de perturbation présentant une épaisseur e3 prise selon la troisième direction z,

- Graver la couche de perturbation de manière à former des corrugations s'étendant principalement selon la deuxième direction y, et présentant une hauteur h3 ≤ e3 selon la troisième direction z.

La hauteur h3 des corrugations est de préférence supérieure à 10 nm, et de préférence supérieure à 20 nm. La gravure d'une telle hauteur h3 est plus facilement réalisable qu'une gravure de moins de quelques nanomètres, par exemple de moins de 5 nm. L'étape de gravure des corrugations selon le procédé de l'invention est donc simplifiée par rapport à une solution visant à diminuer la hauteur des corrugations. Avantageusement, la couche de séparation peut servir de couche d'arrêt à la gravure de la couche de perturbation et h3 = e3. Ainsi, la hauteur h3 des corrugations est parfaitement reproductible et bien maîtrisée. La face du ruban est en outre protégée d'une éventuelle surgravure lors de la gravure des corrugations. Cela permet de réaliser un miroir de Bragg présentant un facteur de qualité élevé.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

- Les figures 1A et 1B illustrent respectivement en vue de dessus et en coupe une architecture connue de source laser à semiconducteurs.
- La figure 2 représente un spectre d'émission typique d'un laser.
- La figure 3A illustre la réflectivité et la stopband des miroirs de confinement et de sortie d'un laser selon l'art antérieur.
- La figure 3B illustre en coupe un miroir de Bragg présentant des corrugations selon l'art antérieur.
- La figure 4A montre une vue en coupe dans un plan yz d'un miroir de Bragg selon un mode de réalisation de la présente invention.
- La figure 4B montre une vue en coupe dans un plan xz d'un miroir de Bragg selon un mode de réalisation de la présente invention.
- La figure 5A montre une vue de dessus d'un miroir de Bragg selon un mode de réalisation de la présente invention.
- La figure 5B montre une vue de dessus d'un miroir de Bragg selon un autre mode de réalisation de la présente invention.
- La figure 6A montre la réflectivité et la stopband d'un miroir de Bragg selon l'art antérieur.
- La figure 6B montre la réflectivité et la stopband d'un miroir de Bragg selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives des différentes couches et corrugations du miroir de Bragg ne sont pas représentatives de la réalité.

DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement :

Selon un exemple, les corrugations sont séparées les unes des autres de sorte que la couche de séparation est exposée entre lesdites corrugations.
Selon un exemple, les corrugations sont encapsulées dans une couche d'encapsulation à base du deuxième matériau.
Selon un exemple, la hauteur h3 des corrugations est supérieure ou égale à 5 nm et/ou inférieure ou égale à 30 nm.
Selon un exemple, l'épaisseur e2 de la couche de séparation est supérieure ou égale à 10 nm et/ou inférieure ou égale à 50 nm.
Selon un exemple, les corrugations présentent un motif adiabatique en projection dans un plan d'extension principal xy formé par les première et deuxième directions x, y.
Selon un exemple, la hauteur h3 et l'épaisseur e2 sont configurées de sorte que le miroir présente une largeur de bande spectrale $\delta\omega_{DBR}$ inférieure ou égale à 0,5 nm.
Selon un exemple, le premier indice de réfraction n1 est supérieur ou égal à 3, le deuxième indice de réfraction n2 est inférieur ou égal à 2, et le troisième indice de réfraction n3 est supérieur ou égal à 1,5.
Selon un exemple, les troisième et deuxième indices de réfraction sont tels que n3 - n2 ≤ 0,5.
Selon un exemple, le premier matériau est du silicium, le deuxième matériau est un oxyde de silicium, le troisième matériau est pris parmi un nitrure de silicium, un nitrure d'aluminium, un oxyde d'aluminium, un oxyde de tantale.
Selon un exemple, le ruban forme un guide monomode.
Selon un exemple, la première partie de ruban est configurée pour coopérer avec un ruban formant un guide monomode.
Selon un exemple, le miroir présente une entrée et une sortie s'étendant selon un plan transverse à la première direction x de propagation du rayonnement lumineux. Le miroir est ainsi apte à admettre et renvoyer le rayonnement lumineux dans une troisième partie du ruban, couplée à la première partie.
Selon un exemple, les corrugations sont comprises dans une couche, dite couche de perturbation, parallèle à la première direction x de propagation du rayonnement lumineux.
Selon un exemple, la première partie du ruban repose sur une couche sous-jacente présentant un indice de réfraction inférieur au premier indice de réfraction n1, de sorte que le rayonnement lumineux soit confiné selon la troisième direction (z).

Selon un exemple, la première partie du ruban présente des flancs latéraux parallèles à un plan xz, et les flancs latéraux sont bordés par au moins une couche latérale présentant un indice de réfraction inférieur au premier indice de réfraction n1, de sorte que le rayonnement lumineux soit confiné selon la deuxième direction (y).

Selon un exemple, le miroir forme avec le ruban un système optique. Ce système optique comprenant le miroir et le ruban peut avantageusement être mis en oeuvre dans le cadre de la réalisation de dispositifs en optique guidée, par exemple des lasers.

Selon un exemple, la première partie du ruban correspond à une partie centrale de plus grande épaisseur d'un guide en arête.

L'invention selon un autre aspect comprend notamment les caractéristiques optionnelles ci-après pouvant être utilisées en association ou alternativement :

Selon un exemple, le procédé comprend en outre une encapsulation des corrugations par une couche d'encapsulation à base du deuxième matériau.

Selon un exemple, l'arrêt de la gravure est effectué au niveau d'une interface entre la couche de séparation et la couche de perturbation, de sorte que la hauteur h3 des corrugations soit égale à l'épaisseur e3 de la couche de perturbation.

Selon un exemple, la gravure présente une sélectivité $S_{p:s}$ entre les couches de perturbation et de séparation supérieure ou égale à 2 :1, préférentiellement supérieure ou égale à 50:1.

Selon un exemple, la hauteur h3 des corrugations est supérieure ou égale à 5 nm et/ou inférieure ou égale à 30 nm et l'épaisseur e2 de la couche de séparation est supérieure ou égale à 20 nm et/ou inférieure ou égale à 50 nm.

Sauf incompatibilité, il est entendu que le miroir, le procédé de fabrication, et le système optique peuvent comprendre, *mutatis mutandis,* l'ensemble des caractéristiques optionnelles ci-dessus.

Dans le cadre de la présente invention, les locutions « miroir de Bragg », « réseau de Bragg » ou « réflecteur de Bragg distribué » ou encore « DBR (Distributed Bragg Reflector) » sont employées en synonymes. Le miroir de Bragg est ici configuré pour être utilisé comme réflecteur dans un guide d'onde. Il comprend une alternance de matériaux d'indices de réfraction différents. Cette alternance induit une variation périodique de l'indice de réfraction effectif dans le guide d'onde. Une telle alternance est reproduite au moins deux fois dans le cadre d'un miroir de Bragg selon la présente invention.

Le guide d'onde coopérant avec le miroir de Bragg est de préférence un guide d'onde de type ruban notamment utilisé pour des applications de laser à ruban. Un laser à ruban peut être de type DBR (pour *Distributed Bragg Reflector,* soit réflecteur de Bragg distribué en français) ou de type DFB (pour *Distributed FeedBack* ou laser à rétroaction répartie en français). Un laser DBR comprend typiquement deux miroirs de Bragg. Un laser DFB comprend typiquement un seul miroir de Bragg.

Le ruban s'étend de façon continue selon une direction principale x. Il guide la propagation du rayonnement lumineux selon x. Comme illustré à la figure 1A, la section du ruban dans un plan yz n'est pas nécessairement constante le long du ruban 100. En particulier, un ou des fuseaux 101, 102 (ou *taper* en anglais) peuvent localement moduler la propagation du rayonnement lumineux. Cela permet par exemple un passage adiabatique entre la propagation du rayonnement lumineux dans la partie 10 (ruban) de la cavité et la propagation du rayonnement lumineux dans la partie 20 (milieu amplificateur) de la cavité. La section du ruban peut également présenter une forme variable. Selon l'exemple illustré à la figure 1A, elle peut être rectangulaire au niveau des miroirs de Bragg 11, 12, et peut présenter un profil en arrête au niveau de la cavité optique 10. Dans le cadre de la présente invention, le ruban peut désigner un guide en ruban, ou peut désigner une partie seulement d'un guide en arête, typiquement la partie centrale de plus grande épaisseur d'un guide en arête. Ainsi, un guide en arête comprend un ruban au sens de la présente invention.

Le ruban comprend typiquement plusieurs parties contribuant respectivement à la formation du ou des miroirs de Bragg et de la cavité optique d'un laser à ruban de type DBR ou DFB. Comme illustré à la figure 1B, une première partie 110 du ruban 100 correspond à un premier miroir de Bragg 11, une deuxième partie 120 du ruban 100 correspond à un deuxième miroir de Bragg 12, et une troisième partie 130 du ruban 100 correspond à la cavité optique. La partie du ruban comprise dans le miroir de Bragg coopère donc avec le reste du ruban. En ce sens le miroir de Bragg s'entend ici d'un ensemble comprenant non seulement un miroir stricto sensu, mais aussi une partie de ruban formant un milieu de propagation de rayonnement lumineux.

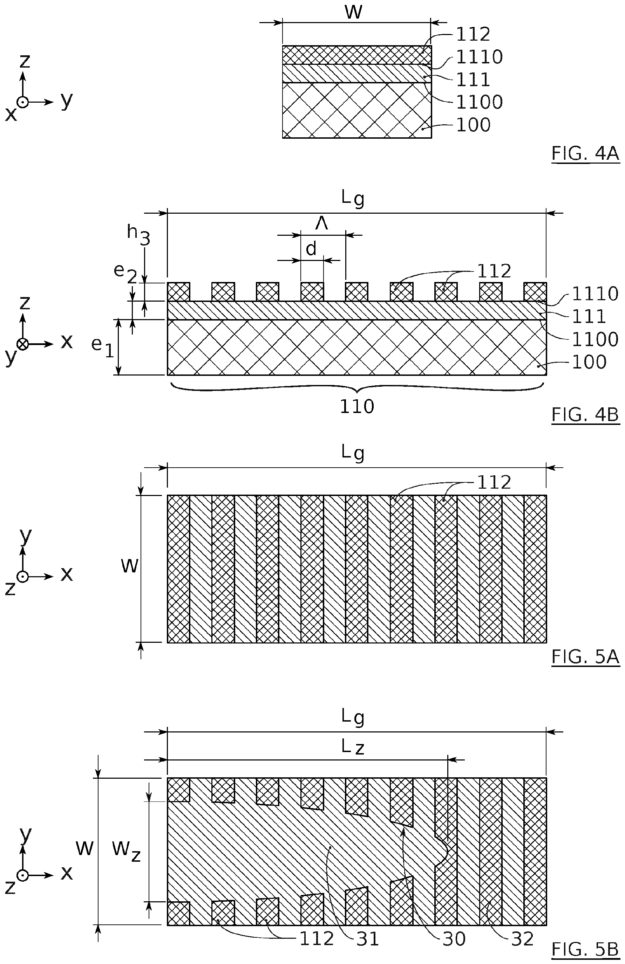

Le ou les miroirs de Bragg comprennent des corrugations au niveau d'au moins une face du ruban. Ces corrugations sont en saillie depuis la face du ruban. Elles s'étendent transversalement à la direction principale longitudinale x. Une « corrugation » correspond donc à un relief transverse proéminent. Les corrugations d'un miroir de Bragg selon l'art antérieur sont typiquement directement au contact de la face du ruban (figure 3B). Les corrugations d'un miroir de Bragg selon la présente invention sont typiquement séparées de la face du ruban par une couche de séparation (figure 4B).

Il est précisé que, dans le cadre de la présente invention, une troisième couche intercalée entre une première couche et une deuxième couche ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément, à moins qu'il n'en soit disposé autrement.

Les étapes de formation des couches, notamment celles de séparation et celle de perturbation s'entendent au sens large : elles peuvent être réalisées en plusieurs sous-étapes qui ne sont pas forcément strictement successives.

On entend par un substrat, un film, une couche, « à base » d'un matériau M, un substrat, un film, une couche comprenant ce matériau M uniquement ou ce matériau M et éventuellement d'autres matériaux, par exemple des éléments d'alliage, des impuretés ou des éléments dopants. Le cas échéant, le matériau M peut présenter différentes stoechiométries. Ainsi, une couche en un matériau à base de nitrure de silicium peut par exemple être une couche de SiN ou une couche de $Si_3N_4$ (généralement appelé nitrure de silicium stoechiométrique).

Dans la présente demande de brevet, les première, deuxième et troisième directions correspondent respectivement aux directions portées par les axes x, y, z d'un repère de préférence orthonormé. Ce repère est représenté sur les figures annexées.

Dans la suite, la longueur est prise selon la première direction x, la largeur est prise selon la deuxième direction y, et l'épaisseur est prise selon la troisième direction z.

Dans la suite, un indice de réfraction est défini pour un matériau, éventuellement pour un matériau moyen ou modèle, et pour une longueur d'onde d'un rayonnement lumineux dans ce matériau. L'indice de réfraction est égal au rapport de la célérité c (vitesse de la lumière dans le vide) sur la vitesse de propagation de la lumière dans le matériau considéré. La lumière est supposée se propager selon la direction longitudinale x.

n1 est un premier indice de réfraction pour une propagation d'un flux lumineux de longueur d'onde λ dans le premier matériau.

n2 est un deuxième indice de réfraction pour une propagation d'un flux lumineux de longueur d'onde λ dans le deuxième matériau.

n3 est un troisième indice de réfraction pour une propagation d'un flux lumineux de longueur d'onde λ dans le troisième matériau.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

Pour déterminer la géométrie d'un miroir de Bragg, on peut procéder à des analyses de Microscopie Electronique à Balayage (MEB) ou de Microscopie Electronique en Transmission (MET ou TEM pour l'acronyme anglais de « Transmission Electron Microscopy »). Ces techniques sont bien adaptées pour déterminer les dimensions de structures nanométriques. Elles peuvent être mises en oeuvre à partir de coupes métallurgiques ou de lames minces pratiquées au travers des dispositifs, selon des méthodes typiques d'analyse de construction ou d'ingénierie inverse.

Les compositions chimiques des différents matériaux peuvent être déterminées à partir d'analyses de type EDX ou X-EDS (acronyme de « energy dispersive x-ray spectroscopy » soit spectroscopie à rayons X à dispersion d'énergie en français). Cette technique est bien adaptée pour analyser la composition de structures de petites tailles telles que des corrugations de faibles épaisseurs. Elle peut être mise en oeuvre sur des coupes métallurgiques au sein d'un Microscope Electronique à Balayage (MEB) ou sur des lames minces au sein d'un Microscope Electronique en Transmission (MET).

Les mesures de réflectivité et de stopband d'un miroir de Bragg peuvent être effectuées par spectroscopie infrarouge, par exemple par spectroscopie infrarouge à transformée de Fourier (FTIR). La largeur de stopband d'un miroir de Bragg est mesurée à mi-hauteur. La réflectivité et la stopband d'un miroir de Bragg peuvent également être déterminées par le biais de calculs de différences finies dans le domaine temporel, dites méthodes FDTD (*Finite Difference Time Domain*).

L'invention va maintenant être décrite en détail au travers de quelques modes de réalisation non limitatifs.

En référence aux figures 4A, 4B et 5A, un premier mode de réalisation d'un miroir de Bragg 11 comprend une première partie 110 de ruban 100 en silicium, une couche de séparation 111 en oxyde de silicium directement formée sur une face 1100 de la partie 110, et des corrugations 112 en nitrure de silicium directement formées sur une face 1110 de la couche de séparation 111.

La partie 110 peut être alternativement en un alliage de silicium, par exemple du silicium-germanium, ou en germanium. Elle présente un indice de réfraction n1 typiquement supérieur à 3. Elle présente une épaisseur e1 par exemple de l'ordre de 500 nm. Elle peut être formée par lithographie/gravure à partir d'un substrat de type silicium sur isolant SOI ou germanium sur isolant GeOI (respectivement pour *Silicon On Insulator* et *Germanium On Insulator*). Cette partie 110 peut présenter une longueur Lg de l'ordre de 50 μm à 1000 μm, et une largeur W de l'ordre de 5 μm à 20 μm. La partie 110 est ainsi typiquement bordée par une couche d'oxyde sous-jacente et par des couches d'oxyde latérales (non illustré).

La face 1100 de cette partie 110 n'est avantageusement pas structurée, contrairement aux solutions connues recourant à une structuration périodique sous forme de corrugations de la face du ruban. Les problématiques de gravure complexes de corrugations de très faible épaisseur (< 5 nm) sont ainsi avantageusement supprimées. La partie 110 est bordée par la couche de séparation 111 au niveau de sa face 1100.

La couche de séparation 111 présente une épaisseur e2 de préférence comprise entre 10 nm et 50 nm, par exemple comprise entre 20 nm et 40 nm. Elle présente un indice de réfraction n2 inférieur à 2. La formation d'une telle couche de séparation 111 en oxyde de silicium est parfaitement connue et facilement réalisable. Elle peut être formée par oxydation thermique du silicium exposé au niveau de la face 1100 de la partie 110 du ruban 100. Alternativement, elle peut être déposée par des techniques de dépôt, par exemple de type dépôt chimique en phase vapeur CVD (Chemical Vapor Déposition). La couche de séparation 111 couvre toute la face 1100.

Les corrugations 112 sont de préférence directement au contact de la couche de séparation 111. Elles présentent une hauteur h3 supérieure à 5 nm, de préférence supérieure à 10 nm, par exemple de l'ordre de 20 nm à 25 nm, voire jusqu'à environ 50 nm. Une telle gamme de hauteur h3 de corrugations permet un réglage plus fin du facteur de corrugation du miroir.

Les corrugations 112 présentent une longueur *d* et une période *Λ* calculées en fonction de la longueur d'onde λ du rayonnement lumineux.

Typiquement, la longueur d est égale à :

$$d = \frac{\lambda}{4.neff}$$

La période *Λ* est égale à :

$$\Lambda = \frac{\lambda}{2.neff}$$

Pour un rayonnement de longueur d'onde λ environ égale à 1.5 μm, la longueur *d* est typiquement de l'ordre de 150 nm et la période *Λ* est typiquement de l'ordre de 250 nm environ. La largeur des corrugations est de préférence supérieure ou égale à W. Une largeur de corrugations légèrement supérieure à la largeur W du ruban 100 permet de pallier à d'éventuels défauts d'alignement selon z des corrugations vis-à-vis du ruban. La probabilité que les corrugations 112 couvrent toute la largeur W du ruban est ainsi améliorée. Le dimensionnement des corrugations dans le plan xy est connu en soi.

Les corrugations présentent un indice de réfraction n3 supérieur à 1,5 et supérieur à n2. Elles sont de préférence en nitrure de silicium. Elles peuvent être alternativement et non limitativement en nitrure d'aluminium, ou en oxyde d'aluminium, ou en oxyde de tantale.

La formation des corrugations se fait de préférence en deux étapes. Une première étape consiste à déposer, par exemple par CVD, une couche dite de perturbation sur la couche de séparation 111. Cette couche de perturbation présente une épaisseur e3. Une deuxième étape consiste à structurer la couche de perturbation par lithographie/gravure de façon à former les corrugations 112. La gravure se fait de préférence par voie sèche. La profondeur de gravure correspond à la hauteur h3 des corrugations. Les corrugations 112 sont de préférence distinctes et séparées les unes des autres, tel qu'illustré à la figure 4B. Dans ce cas, h3 = e3 et la face 1110 de la couche de séparation 111 est exposée entre les corrugations à l'issue de la gravure. La couche de séparation 111 sert dès lors avantageusement de couche d'arrêt à la gravure. La gravure présente de préférence une sélectivité $S_{p:s}$ entre les couches de perturbation et de séparation supérieure ou égale à 2:1, dans le cas d'une gravure sèche, voire à 50:1, notamment dans le cas d'une gravure humide.

Alternativement, les corrugations 112 présentent une hauteur h3 inférieure à l'épaisseur e3 de la couche de perturbation. Elles sont reliées entre elles par une partie inférieure de la couche de perturbation au contact de la couche de séparation 111. La gravure est dans ce cas stoppée avant d'atteindre la face 1110 de la couche de séparation 111.

Après gravure, les corrugations 112 sont de préférence encapsulées par un dépôt d'oxyde de silicium, par exemple par CVD. La couche d'encapsulation recouvre de préférence l'ensemble de la face du miroir comprenant les corrugations et opposées au ruban ; elle remplit aussi avantageusement les espaces entre les corrugations, recouvrant ainsi les portions exposées de la couche de séparation (qui s'entendent des portions non recouvertes par des corrugations).

Selon ce premier mode de réalisation, les corrugations s'apparentent ainsi à des barreaux de nitrure de silicium noyés dans une matrice d'oxyde de silicium, tel qu'illustré à la figure 5A. Les corrugations présentent de préférence une largeur constante. Le miroir de Bragg ainsi formé comprend quelques dizaines de corrugations sur sa longueur Lg. Le nombre de corrugations est par exemple compris entre 10 et 100.

Selon un deuxième mode de réalisation illustré à la figure 5B, les corrugations 112 sont arrangées selon un motif dit adiabatique. Seul cet arrangement des corrugations diffère du premier mode de réalisation, toutes choses étant égales par ailleurs. Un tel motif adiabatique présente dans le plan xy un profil 30 effilé, par exemple en pointe ou en parabole, délimitant une première zone 31 sans corrugations et une deuxième zone 32 avec corrugations 112. La face 1110 de la couche de séparation 111 est dans ce cas exposée sur toute la zone 31 dépourvue de corrugations 112. La zone 31 est de préférence centrée sur la zone 32 selon la direction y.

Un tel motif adiabatique permet de façon connue de moduler progressivement la propagation du rayonnement lumineux lors de la réflexion sur le miroir de Bragg. Cela permet de limiter les pertes optiques par diffraction au niveau du miroir de Bragg. Les pertes parasites de la cavité optique sont ainsi limitées. La zone 31 présente ainsi une largeur progressivement décroissante depuis un premier côté du miroir destiné à jouxter la cavité optique ou le guide d'onde dans lequel se propage le rayonnement lumineux, vers le deuxième côté du miroir opposé au premier côté selon la direction x. La zone 32 comprend des parties de corrugations bordant la zone 31, et des corrugations complètes - c'est-à-dire s'étendant selon toute la largeur W - au niveau du deuxième côté du miroir. Le nombre de corrugations complètes de la zone 32 peut être compris entre 5 et 20.

La largeur maximale Wz de la zone 31 est de préférence inférieure à la largeur W de la zone 32. Le rapport des largeurs Wz/W peut être compris entre 0,5 et 0,9. La longueur Lz de la zone 31 est inférieure à la longueur Lg de la zone 32. Le rapport des longueurs Lz/Lg peut être compris entre 0,5 et 0,9. La surface de la zone 31 peut être inférieure à celle de la zone 32. Le rapport des surfaces des zones 31, 32 peut être compris entre 0,5 et 0,9.

Les miroirs de Bragg ainsi formés selon ces premier et deuxième modes de réalisation présentent une largeur de stopband réduite. Le miroir de Bragg formé selon le deuxième mode de réalisation présente en outre une efficacité améliorée.

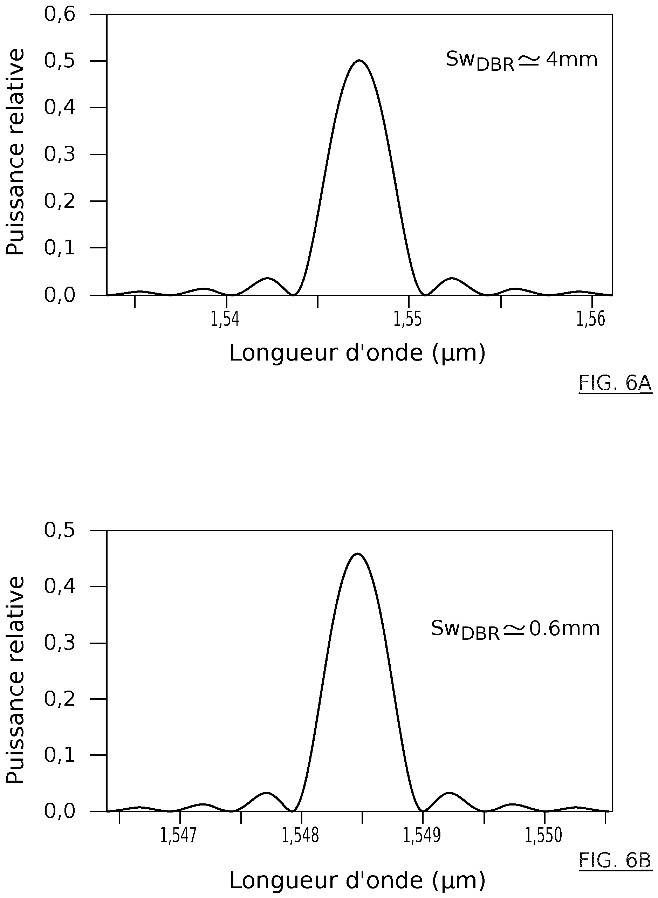

Les figures 6A et 6B comparent les largeurs de stopband $\delta\omega_{DBR}$ d'un miroir selon l'art antérieur (figure 6A) et d'un miroir selon la présente invention (figure 6B). Pour des réflectivités similaires de l'ordre de 50%, la largeur de stopband du miroir selon l'invention ($\delta\omega_{DBR} \approx 0,6$ nm, figure 6B) est très significativement réduite en comparaison de la largeur de stopband du miroir selon l'art antérieur ($\delta\omega_{DBR} \approx 4$ nm, figure 6A). Une largeur de stopband $\delta\omega_{DBR} \approx 0,6$ nm présentée dans cet exemple n'est pas une valeur limite de largeur de stopband d'un miroir selon l'invention. Cette largeur de stopband peut encore être diminuée, par exemple en augmentant l'épaisseur e2 de la couche de séparation et/ou en diminuant la hauteur h3 des corrugations.

Un tel miroir de Bragg peut avantageusement être mis en oeuvre en tant que miroir de sortie d'un laser à ruban de type DBR. En particulier, l'architecture dite III-V sur Si illustrée aux figures 1A et 1B peut être utilisée en remplaçant le miroir 11 selon l'art antérieur par le miroir de Bragg décrit dans la présente invention. L'utilisation de ce miroir à largeur de stopband réduite permet d'allonger la cavité optique 10 tout en conservant un faisceau laser monomode. En allongeant la cavité optique d'un facteur X par rapport à une longueur L d'une cavité d'un laser pris comme référence, l'intervalle spectral libre $ISL_\lambda$ est réduit du même facteur X. Pour conserver le rapport SMSR du faisceau laser de référence, il est alors nécessaire de réduire la largeur de stopband de ce même facteur X.

Il apparaît donc clairement que le miroir de Bragg selon l'invention convient à la réalisation de laser à ruban III-V sur Si de type DBR présentant une cavité optique X fois plus grande que celle du laser de référence. En augmentant proportionnellement la longueur, et donc le volume, du milieu amplificateur, la puissance d'un tel laser est également environ X fois supérieure à celle du laser de référence. Le miroir de Bragg selon l'invention permet donc de réaliser un laser III-V sur Si environ X fois plus puissant qu'un laser de référence comprenant un miroir de Bragg selon l'art antérieur. Ce facteur X est d'au moins 6 dans le cadre de la présente invention.

Un laser III-V sur Si comprenant un miroir de sortie tel que décrit dans la présente invention peut ainsi présenter une longueur de cavité L de l'ordre de 3 mm, une longueur de milieu amplificateur de l'ordre de 2 mm et un $ISL_\lambda$ de l'ordre de 0,11 nm. Un tel laser présente avantageusement une puissance optique supérieure ou égale à 100 mW, en conservant un SMSR supérieur à 30 dB pour une longueur d'onde d'émission de l'ordre de 1,5 $\mu$m. Le miroir 12 de confinement de ce laser comprend de préférence des corrugations formées directement sur la partie 120 du ruban 100. Il présente ainsi une largeur de stopband très supérieure à celle du miroir 11 de sortie. Cela permet de bénéficier d'une réflectivité quasi-totale (R ≥ 99%) sur une large bande (par exemple $\delta\omega_{DBR2} \geq 10$ nm) pour le miroir 12, et d'une semi-réflectivité (R ≤ 50%) sur une bande très fine (par exemple $\delta\omega_{DBR} \leq 0,6$ nm) pour le miroir 11. Un tel laser est avantageusement utilisable pour des applications LiDAR et télécom 400G longue distance.

L'invention n'est pas limitée aux modes de réalisations précédemment décrits et s'étend à tous les modes de réalisation couverts par les revendications.

## Revendications

1. Miroir de Bragg (11) comprenant une première partie (110) de ruban (100) à base d'un premier matériau présentant un premier indice de réfraction n1, ledit ruban (100) s'étendant principalement selon une première direction (x) et étant destiné à guider une propagation d'un rayonnement lumineux de longueur d'onde λ selon ladite première direction (x), le miroir de Bragg (11) comprenant en outre des corrugations (112) au niveau d'au moins une face (1100) de ladite première partie (110) de ruban (100), lesdites corrugations (112) s'étendant principalement selon une deuxième direction (y) normale à la première direction (x) et présentant une hauteur h3 selon une troisième direction (z) normale aux première et deuxième directions (x, y), le miroir de Bragg (11) étant **caractérisé en ce que** les corrugations (112) sont séparées de ladite au moins une face (1100) de la première partie (110) de ruban (100) par une couche de séparation (111) à base d'un deuxième matériau présentant une épaisseur e2 prise selon la troisième direction (z) et présentant un deuxième indice de réfraction n2, lesdites corrugations (112) étant encapsulées dans une couche d'encapsulation à base du deuxième matériau, et **en ce que** les corrugations (112) sont à base d'un troisième matériau présentant un troisième indice de réfraction n3, tel que n2 < n3 et n2 < n1.

2.  Miroir selon la revendication précédente dans lequel les corrugations (112) sont séparées les unes des autres de sorte que la couche de séparation (111) est exposée entre lesdites corrugations.

3.  Miroir selon l'une quelconque des revendications précédentes dans lequel la hauteur h3 des corrugations est supérieure ou égale à 5 nm et/ou inférieure ou égale à 30 nm.

4.  Miroir selon l'une quelconque des revendications précédentes dans lequel l'épaisseur e2 de la couche de séparation (111) est supérieure ou égale à 10 nm et/ou inférieure ou égale à 50 nm.

5.  Miroir selon l'une quelconque des revendications précédentes dans lequel les corrugations présentent un motif (30) adiabatique en projection dans un plan d'extension principal (xy) formé par les première et deuxième directions (x, y).

6.  Miroir selon l'une quelconque des revendications précédentes dans lequel la hauteur h3 et l'épaisseur e2 sont configurées de sorte que le miroir (11) présente une largeur de bande spectrale $\delta\omega_{DBR}$ inférieure ou égale à 0,5 nm.

7.  Miroir selon l'une quelconque des revendications précédentes dans lequel le premier indice de réfraction n1 est supérieur ou égal à 3, le deuxième indice de réfraction n2 est inférieur ou égal à 2, et le troisième indice de réfraction n3 est supérieur ou égal à 1,5.

8.  Miroir selon l'une quelconque des revendications précédentes dans lequel les troisième et deuxième indices de réfraction sont tels que n3 - n2 ≤ 0,5.

9.  Miroir selon l'une quelconque des revendications précédentes dans lequel la première partie (110) de ruban (100) est configurée pour coopérer avec un ruban (100) formant un guide monomode.

10. Miroir selon l'une quelconque des revendications précédentes dans lequel la première partie du ruban (100) repose sur une couche sous-jacente présentant un indice de réfraction inférieur au premier indice de réfraction n1, de sorte que le rayonnement lumineux soit confiné selon la troisième direction (z).

11. Procédé de fabrication d'un miroir de Bragg (11) comprenant les étapes suivantes :

    - Fournir un ruban (100) à base d'un premier matériau présentant un premier indice de réfraction n1, ledit ruban (100) s'étendant principalement selon une première direction (x) et présentant une face (1100) s'étendant dans un plan d'extension principal (xy) formé par la première direction (x) et une deuxième direction (y) normale à la première direction (x),
    - Déposer au moins sur une première partie de ladite face (1100) du ruban une couche de séparation (111) à base d'un deuxième matériau présentant un deuxième indice de réfraction n2 tel que n2 < n1, ladite couche de séparation (111) présentant une épaisseur e2 prise selon une troisième direction (z) normale aux première et deuxième directions (x, y),
    - Déposer, sur la couche de séparation (111), une couche de perturbation à base d'un troisième matériau présentant un troisième indice de réfraction n3, tel que n2 < n3, ladite couche de perturbation présentant une épaisseur e3 prise selon la troisième direction (z),
    - Graver la couche de perturbation de manière à former des corrugations (112) s'étendant principalement selon la deuxième direction (y), et présentant une hauteur h3 ≤ e3 selon la troisième direction (z)
    - Encapsuler les corrugations (112) par une couche d'encapsulation à base du deuxième matériau.

12. Procédé selon la revendication précédente dans lequel l'arrêt de la gravure est effectué au niveau d'une interface (1110) entre la couche de séparation (111) et la couche de perturbation, de sorte que la hauteur h3 des corrugations (112) soit égale à l'épaisseur e3 de la couche de perturbation.

13. Procédé selon l'une quelconque des deux revendications précédentes dans lequel la hauteur h3 des corrugations (112) est supérieure ou égale à 5 nm et/ou inférieure ou égale à 30 nm et l'épaisseur e2 de la couche de séparation (111) est supérieure ou égale à 20 nm et/ou inférieure ou égale à 50 nm.

**Patentansprüche**

1.  Bragg-Spiegel (11), der einen ersten Teil (110) eines Bandes (100) auf der Grundlage eines ersten Werkstoffs, der einen ersten Brechungsindex n1 aufweist, umfasst, wobei sich das Band (100) hauptsächlich entlang einer ersten Richtung (x) erstreckt und dazu bestimmt ist, eine Ausbreitung eines Lichtstrahls mit Wellenlänge λ entlang der ersten Richtung (x) zu führen, wobei der Bragg-Spiegel (11) außerdem Wellungen (112) im Bereich mindestens einer Fläche (1100) des ersten Teils (110) von Band (100) umfasst, wobei sich die Wellungen (112) hauptsächlich entlang einer zweiten Richtung (y) normal zu der ersten Richtung (x) erstrecken und eine Höhe h3 entlang einer dritten Richtung (z) normal zu der ersten und der zweiten Richtung (x, y) aufweisen, wobei der Bragg-Spiegel (11) **dadurch gekennzeichnet ist, dass** die Wellungen (112) von der mindestens einen Fläche (1100) des ersten Teils (110) von Band (100) durch eine Trennschicht (111) auf der Grundlage eines zweiten Werkstoffs getrennt sind, der eine Dicke e2 entlang der dritten Richtung (z) genommen aufweist, und einen zweiten Brechungsindex n2 aufweist, wobei die Wellungen (112) in einer Kapselungsschicht auf der Grundlage des zweiten Werkstoffs gekapselt sind, und dass die Wellungen (112) auf der Grundlage eines dritten Werkstoffs sind, der einen dritten Brechungsindex n3 aufweist, so dass n2 < n3 und n2 < n1.

2. Spiegel nach dem vorstehenden Anspruch, wobei die Wellungen (112) voneinander derart getrennt sind, dass die Trennschicht (111) zwischen den Wellungen exponiert ist.

3. Spiegel nach einem der vorstehenden Ansprüche, wobei die Höhe h3 der Wellungen größer oder gleich 5 nm und/oder kleiner oder gleich 30 nm ist.

4. Spiegel nach einem der vorstehenden Ansprüche, wobei die Dicke e2 der Trennschicht (111) größer oder gleich 10 nm und/oder kleiner oder gleich 50 nm ist.

5. Spiegel nach einem der vorstehenden Ansprüche, wobei die Wellungen eine adiabatische Struktur (30) in Projektion in einer Hauptausdehnungsebene (xy), die von der ersten und der zweiten Richtung (x, y) gebildet wird, aufweisen.

6. Spiegel nach einem der vorstehenden Ansprüche, wobei die Höhe h3 und die Dicke e2 derart konfiguriert sind, dass der Spiegel (11) eine spektrale Bandbreite $\delta\omega_{DBR}$ kleiner oder gleich 0,5 nm aufweist.

7. Spiegel nach einem der vorstehenden Ansprüche, wobei der erste Brechungsindex n1 größer oder gleich 3 ist, der zweite Brechungsindex n2 kleiner oder gleich 2 ist, und der dritte Brechungsindex n3 größer oder gleich 1,5 ist.

8. Spiegel nach einem der vorstehenden Ansprüche, wobei der dritte und der zweite Brechungsindex derart sind, dass n3 - n2 ≤ 0,5.

9. Spiegel nach einem der vorstehenden Ansprüche, wobei der erste Teil (110) von Band (100) dazu konfiguriert ist, mit einem Band (100), das eine Monomode-Führung bildet, zusammenzuwirken.

10. Spiegel nach einem der vorstehenden Ansprüche, wobei der erste Teil des Bandes (100) auf einer darunterliegenden Schicht ruht, die einen Brechungsindex kleiner als der erste Brechungsindex n1 derart aufweist, dass der Lichtstrahl entlang der dritten Richtung (z) beschränkt ist.

11. Verfahren zur Herstellung eines Bragg-Spiegels (11), das die folgenden Schritte aufweist:

- Bereitstellen eines Bandes (100) auf der Grundlage eines ersten Werkstoffs, der einen Brechungsindex n1 aufweist, wobei sich das Band (100) hauptsächlich entlang einer ersten Richtung (x) erstreckt und eine Fläche (1100) aufweist, die sich in einer Hauptausdehnungsebene (xy), die von der ersten Richtung (x) und einer zweiten Richtung (y) normal zu der ersten Richtung (x) gebildet ist, erstreckt,
- Aufbringen auf mindestens einem ersten Teil der Fläche (1100) des Bandes einer Trennschicht (111) auf der Grundlage eines zweiten Werkstoffs, der einen zweiten Brechungsindex n2 derart aufweist, dass n2 < n1, wobei die Trennschicht (111) eine Dicke e2 entlang einer dritten Richtung (z) normal zu der ersten und der zweiten Richtung (x, y) aufweist,
- Aufbringen auf der Trennschicht (111) einer Störungsschicht auf der Grundlage eines dritten Werkstoffs, der einen dritten Brechungsindex n3 derart aufweist, dass n2 < n3, wobei die Störungsschicht eine Dicke e3 entlang der dritten Richtung (z) genommen aufweist,
- Ätzen der Störungsschicht derart, dass Wellungen (112) gebildet werden, die sich hauptsächlich entlang der zweiten Richtung (y) erstrecken und eine Höhe h3 ≤ e3 entlang der dritten Richtung (z) aufweisen,
- Kapseln der Wellungen (112) durch eine Kapselungsschicht auf der Grundlage des zweiten Werkstoffs.

12. Verfahren nach dem vorstehenden Anspruch, wobei das Stoppen des Ätzens im Bereich einer Grenzfläche (1110) zwischen der Trennschicht (111) und der Störungsschicht derart durchgeführt wird, dass die Höhe h3 der Wellungen (112) gleich der Dicke e3 der Störungsschicht ist.

13. Verfahren nach einem der zwei vorstehenden Ansprüche, wobei die Höhe h3 der Wellungen (112) größer oder gleich 5 nm und/oder kleiner oder gleich 30 nm ist, und die Dicke e2 der Trennschicht (111) größer oder gleich 20 nm und/oder kleiner oder gleich 50 nm ist.

**Claims**

1. Bragg mirror (11) comprising a first part (110) of a strip (100) with the basis of a first material having a first refraction index n1, said strip (100) extending mainly in a first direction (x) and being intended to guide a propagation of a light radiation of wavelength λ in said first direction (x), the Bragg mirror (11) further comprising corrugations (112) at at least one face (1100) of said first part (110) of a strip (100), said corrugations (112) extending mainly in a second direction (y) normal to the first direction (x) and having a height h3 in a third direction (z) normal to the first and second directions (x, y), the Bragg mirror (11) being **characterised in that** the corrugations (112) are separated from said at least one face (1100) of the first part (110) of a strip (100) by a separation layer (111) with the basis of a second material having a thickness e2 taken in the third direction (z), and having a second refraction index n2, said corrugations (112) being encapsulated in an encapsulation layer with the basis of the second material, and **in that** the corrugations (112) are with the basis of a third material having a third refraction index n3, such that n2 < n3 and n2 < n1.

2. Mirror according to the preceding claim, wherein the corrugations (112) are separated from one another, such that the separation layer (111) is exposed between said corrugations.

3. Mirror according to any one of the preceding claims, wherein the height h3 of the corrugations is greater than or equal to 5nm and/or less than or equal to 30nm.

4. Mirror according to any one of the preceding claims, wherein the thickness e2 of the separation layer (111) is greater than or equal to 10nm and/or less than or equal to 50nm.

5. Mirror according to any one of the preceding claims, wherein the corrugations have an adiabatic pattern (30) projecting in a main extension plane (xy) formed by the first and second directions (x, y).

6. Mirror according to any one of the preceding claims, wherein the height h3 and the thickness e2 are configured, such that the mirror (11) has a spectral band width $\delta\omega_{DBR}$ less than or equal to 0.5nm.

7. Mirror according to any one of the preceding claims, wherein the first refraction index n1 is greater than or equal to 3, the second refraction index n2 is less than or equal to 2, the third refraction index n3 is greater than or equal to 1.5.

8. Mirror according to any one of the preceding claims, wherein the third and second refraction indices are such that n3 - n2 ≤ 0.5.

9. Mirror according to any one of the preceding claims, wherein the first part (110) of the strip (100) is configured to engage with a strip (100) forming a single-mode guide.

10. Mirror according to any one of the preceding claims, wherein the first part of the strip (100) rests on an underlying layer having a refraction index less than the first refraction index n1, such that the light radiation is confined in the third direction (z).

11. Method for manufacturing a Bragg mirror (11) comprising the following steps:

    - Providing a strip (100) with the basis of a first material having a first refraction index n1, said strip (100) extending mainly in a first direction (x) and having a face (1100) extending in a main extension plane (xy) formed by the first direction (x) and a second direction (y) normal to the first direction (x),
    - Depositing at least on a first part of said face (1100) of the strip, a separation layer (111) with the basis of a second material having a second refraction index n2 such that n2 < n1, said separation layer (111) having a thickness e2 taken in a third direction (z) normal to the first and second directions (x, y),
    - Depositing, on the separation layer (111), an interference layer with the basis of a third material having a third refraction index n3, such that n2 < n3, said interference layer having a thickness e3 taken in the third direction (z),
    - Etching the interference layer so as to form corrugations (112) extending mainly in the second direction (y), and having a height h3 ≤ e3 in the third direction (z),
    - Encapsulating the corrugations (112) by an encapsulation layer with the basis of the second material.

12. Method according to the preceding claim, wherein the stopping of the etching is done at an interface (1110) between the separation layer (111) and the interference layer, such that the height h3 of the corrugations (112) is equal to the thickness e3 of the interference layer.

13. Method according to any one of the two preceding claims, wherein the height h3 of the corrugations (112) is greater than or equal to 5nm and/or less than or equal to 30nm and the thickness e2 of the separation layer (111) is greater than or equal to 20nm and/or less than or equal to 50nm.

12    101    100    10,20    102    11

FIG. 1A

12    10    100    20    11

120    130    110

FIG. 1B

M$_{-1}$    M$_0$    ISL$_\lambda$    M$_{+1}$

Intensité

Fréquence

FIG. 2

FIG. 3A

FIG. 3B

W

112
1110
111
1100
100

z
x ⊙ → y

FIG. 4A

Lg

$h_3$

$e_2$

$\Lambda$

d

112

1110
111
1100
100

z
y ⊙ → x

$e_1$

110

FIG. 4B

Lg

112

y
z ⊙ → x

W

FIG. 5A

Lg

$L_z$

y
z ⊙ → x

W

$W_z$

112  31  30  32

FIG. 5B

FIG. 6A

FIG. 6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005089098 A2